# EUROPEAN PATENT APPLICATION

(11) **EP 3 223 515 A1**
(43) Date of publication of application: **27.09.2017**
(21) Application number: 16305307.7
(22) Date of filing: 21.03.2016
(51) Int. Cl.: H04N 5/76, G11B 5/455, G06F 11/34, H04N 5/907

(54) **METHOD FOR TESTING PERFORMANCE OF A STORAGE DEVICE AND CORRESPONDING DEVICE**

(71) Applicant: Thomson Licensing, 92130 Issy-les-Moulineaux (FR)
(72) Inventor: RIGAL, Renaud, 35576 Cesson-Sévigné Cedex (FR); SEINGIER, François-Xavier, 35576 Cesson-Sévigné Cedex (FR); QUERE, Thierry, 35576 Cesson-Sévigné Cedex (FR)
(74) Representative: Huchet, Anne

(57) **Abstract**

Performance evaluation of a storage device, for example a storage device connected to a Set Top Box, for evaluating its suitability for supporting DVR/PVR functions such as recording a broadcast audio/video stream or time shifting a broadcast audio/video stream.

## Description

### FIELD

The present disclosure generally relates to the field of performance testing of storage devices.

### BACKGROUND

Digital video recording (DVR) and Personal Video Recording (PVR) functions are proposed by many audio/video consumer devices. DVR/PVR functions allow a user to record, to playback, and to pause a broadcasted audio/video stream. DVR/PVR functions are proposed on television sets, set top boxes (STB), mobile devices, and personal computers. For reasons of economy and footprint, these devices are commonly not supplied with a storage device required to enable use of the DVR/PVR functions. It is up to the consumer to supply an external storage apparatus and to connect it to a data communication port of the audio/video device. Examples of commonly commercialized storage devices are Universal Serial Bus (USB) Hard Disk Drives (HDD) and memory sticks. Storage devices come in various prices and different quality. Personal computers (PCs) generally have sufficient internal hard disk space for providing a DVR/PVR function. However, the performance of DVR/PVR read-write operations can be degraded by other tasks that are simultaneously executed by the PC and that also make use of the internal storage device, and which are not under control of the audio/video application.

If the performance of a storage device used for DVR/PVR functionality is insufficient, the DVR/PVR function will be adversely affected, resulting in visible and audible artefacts such as macroblocks and audio/video glitches. Consumers may mistakenly conclude that the audio/video device is defective, resulting in a considerable workload for helpdesk and after-sales services.

There is thus a need for performance testing of storage devices.

### SUMMARY

The present disclosure aims at alleviating at least some of the deficiencies discussed in the background section.

To this end, the present principles comprise a method for evaluating performance of a storage device connected to a host device. The method is implemented by the host device. The method comprises binary reading a memory segment from the storage device; saving the memory segment via the host device to a storage space different from the storage device; executing binary read-write tests on the memory segment in the storage device; determining a performance profile for the storage device according to a result of the binary read-write tests executed on the memory segment in the storage device; and restoring the saved memory segment to the storage device by binary writing the saved memory segment via the host device to the memory segment in the storage device.

According to a variant embodiment of the method for evaluating performance of a storage device connected to a host device, the execution of the binary read-write tests on the memory segment in the storage device comprises determining a read-write bit rate.

According to a variant embodiment of the method for evaluating performance of a storage device connected to a host device, the execution of the binary read-write tests on the memory segment in the storage device comprises determining a maximum number of supported simultaneous read-write operations.

According to a variant embodiment of the method for evaluating performance of a storage device connected to a host device, the determining of the performance profile comprises classifying of the storage device in a video resolution class for storing and retrieving video data from the storage device according to the result of the binary read-write tests executed on the memory segment in the storage device.

According to a variant embodiment of the method for evaluating performance of a storage device connected to a host device, the video resolution class is one of a standard definition video resolution class, a high definition video resolution class, or an ultra-high definition video resolution class.

According to a variant embodiment of the method for evaluating performance of a storage device connected to a host device, the determining of the performance profile comprises classifying of the storage device in a personal video recording type class according to a the determined read-write bit rate.

According to a variant embodiment of the method for evaluating performance of a storage device connected to a host device, the personal video recording type class is one of a recording or time shift class or a recording and time shift class.

According to a variant embodiment of the method for evaluating performance of a storage device connected to a host device, the performance profile is saved in the host device.

According to a variant embodiment of the method for evaluating performance of a storage device connected to a host device, the performance profile is saved in a network storage area.

The present disclosure also relates to a host device for evaluating read-write performance of a storage device connected to the host device, comprising a processor and memory configured to: binary read a memory segment from the storage device; save the binary read memory segment via the host device to a storage space different from the storage device; execute binary read-write tests on the memory segment in the storage device; determine a performance profile for the storage device according to a result of the binary read-write tests executed on the memory segment in the storage device; and restore the saved memory segment to the storage device by binary writing the saved memory segment via the host device to the memory segment in the storage device.

According to a variant embodiment of the host device, the processor and the memory are further configured to determine a read-write bit rate from the binary read-write tests executed on the memory segment in the storage device.

According to a variant embodiment of the host device, the processor and the memory are further configured to determine a maximum number of supported simultaneous read-write operations.

According to a variant embodiment of the host device, the processor and the memory are further configured to classify the storage device in a video resolution class for storing and retrieving video data from the storage device according to a maximum supported read-write bit rate determined from the binary read-write tests.

According to a variant embodiment of the host device, the processor and the memory are further configured to classify the storage device in a personal video recording type class according to a the determined read-write bit rate.

According to a variant embodiment of the host device, the processor and the memory are further configured to store the performance profile in the host device.

### BRIEF DESCRIPTION OF THE DRAWINGS

More advantages of the present disclosure will appear through the description of particular, non-restricting embodiments. In order to describe the manner in which the advantages of the present disclosure can be obtained, particular descriptions of the present principles are rendered by reference to specific embodiments thereof which are illustrated in the appended drawings. The drawings depict exemplary embodiments of the disclosure and are therefore not to be considered as limiting its scope. The embodiments described can be combined to form particular advantageous embodiments. In the following figures, items with same reference numbers as items already described in a previous figure will not be described again to avoid unnecessary obscuring the disclosure. The exemplary embodiments will be described with reference to the following figures:
**Figure 1** illustrates an exemplary environment enabling DVR/PVR functions of an audio/video receiver.
**Figure 2** is a schematic view of an exemplary embodiment of the Set-Top Box illustrated in figure 1.
**Figure 3** further illustrates the present principles of evaluating performance of a storage device through binary read-write testing.
**Figure 4** is a flow chart according to a particular embodiment of the present principles.

### DETAILED DESCRIPTION

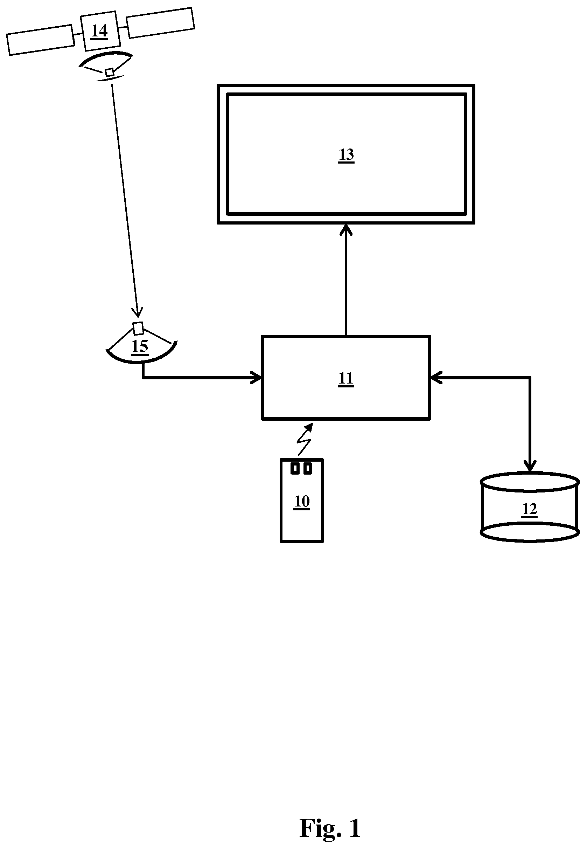

**Figure 1** illustrates an exemplary environment enabling DVR/PVR functions of an audio/video receiver **11**. Audio/video receiver device **11** is a Set-Top Box (STB) for reception of audio/video streams from a satellite **14**, as is well known in the art. The audio/video streams are received from satellite **14** and reception antenna **15**. The STB **11** transmits an audio/video signal to a digital television **13** for rendering. Connected to STB **11** is a storage device **12**. STB **11** is operated through a remote control (RC) **10**.

As briefly discussed in the background section, the audio/video receiver **11** comprises a data communication port (not shown) for connecting the storage device **12**. While the audio/video receiver **11** comprises DVR/PVR functions, it requires the presence of storage device **12** to propose the DVR/PVR functions to the consumer. A storage device is generally not supplied with the audio/video receiver **11** but is to be supplied by the consumer. Consumers have a wide choice of storage device types, models and make. For example, the consumer may provide a USB memory stick. USB memory sticks comply with various standards (e.g., USB 1.0, 2.0 or 3.0) and come in various qualities. It has been found that while USB memory sticks electrically do comply with a given standard, the maximum data transfer rate is sometimes way lower than could have been expected according to the standard it is supposed to comply with. Unlike for USB memory sticks, a speed class rating is defined for storage devices of the SD card type. However, even if it is indicated in a user manual that for good performance of DVR/PVR operations an SD card is to be used with a speed class rating equal or higher than a given value, it cannot be guaranteed that consumers respect this.

It is therefore useful to evaluate the performance of a storage device before starting to use it for DVR/PVR functions in order to avoid malfunctioning of the DVR/PVR functions.

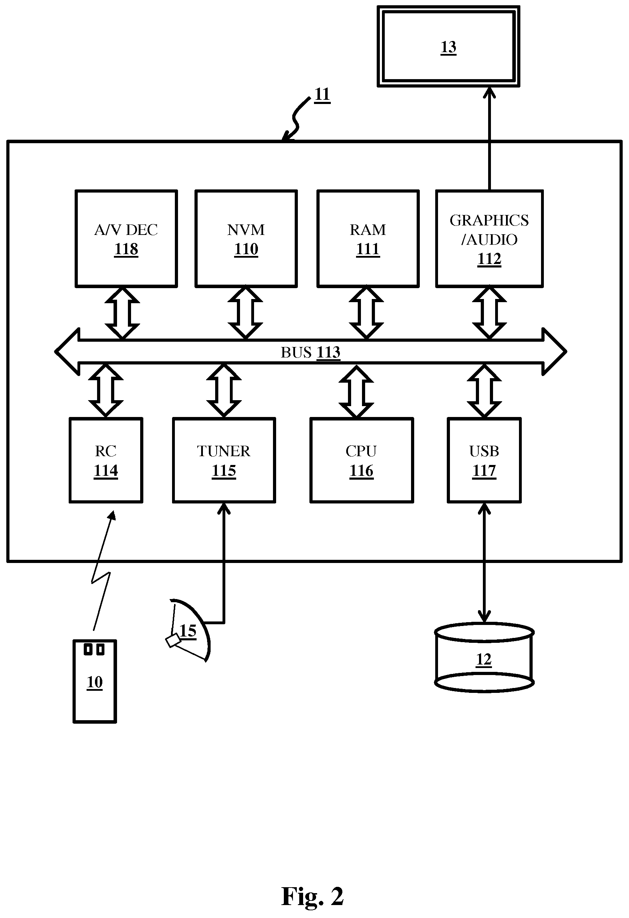

**Figure 2** is a schematic view of an exemplary embodiment of the Set-Top Box illustrated in figure 1. STB **11** comprises: a non-volatile memory (NVM) **110**, a random access memory (RAM) **111**, a graphics and audio controller **112**, a remote control circuit **114**, a tuner **115**, a central processing unit (CPU) **116**, an audio/video decoder (A/V DEC) **118**, and a peripheral interface **117**, e.g., according to the universal serial bus (USB), High Definition Multimedia Interface (HDMI), Ethernet, WiFi, Bluetooth, or Serial ATA (SATA), to name some. All these components are interconnected by means of an internal data and communication bus **113**. Remote control circuit **114** is configured to receive remote control commands from remote controller **10**. Tuner **115** is configured to receive audio/video streams from satellite antenna **15**. Peripheral interface **117** is configured to be connected to storage device **12**. Graphics controller **112** is configured to be connected to display **13** for rendering of audio/video. STB memory comprises NVM **110** and RAM **111**. NVM **110** comprises for example a set of computer-readable program instructions that are executable by CPU **116** and that comprise the program for implementing functions of device **11**. For example, the set of program instructions comprise firmware, middleware and application programs. NVM **110** may also comprise parameters and variables used for operating STB **11**, such as a channel list, user preferences, and internal parameters and variables used for the program instructions. RAM **111** is used for temporary storage of program instructions, variables and parameters. Graphics and audio card **112** is configured to drive audio/video rendering device **13**. Audio/video decoder **118** is configured to decode audio/video streams.

During operation of STB **11**, a user selects an audio/video channel to tune to using remote control **10**. A corresponding instruction is sent to CPU **116**, which retrieves a channel list from NVM **110**, extracts associated tuning parameters from the channel list, and instructs tuner **115** to tune to a frequency indicated by the extracted tuning parameters. The tuner **115** then receives an audio/video stream broadcasted on the given frequency and transfers the received audio/video stream to audio/video decoder **118**. The audio/video decoder **118** transfers decoded audio/video to graphics/audio controller **112**, which outputs audio/video to rendering device **13**. When the user presses a pause button on remote control **10** to pause the broadcast channel received, STB **11** stores the audio/video stream received from tuner **115** on storage device **12**. When the user then resumes playing, STB **11** transfers the stored audio/video stream to audio/video decoder **118** and decoded audio/video is rendered on rendering device **13**. During this time, STB **11** continues to store the audio/video broadcast stream received from tuner **115** on storage device **12**. In this configuration, storage device **12** is used as a buffer memory for a time shift operation. It can thus be seen that the time shift requires simultaneous read and write operation on storage device **12**. The read-write performance of storage device **12** should be sufficient to support the resulting high data communication rate and frequent alternation of read-write operations if the time shift feature is to function correctly.

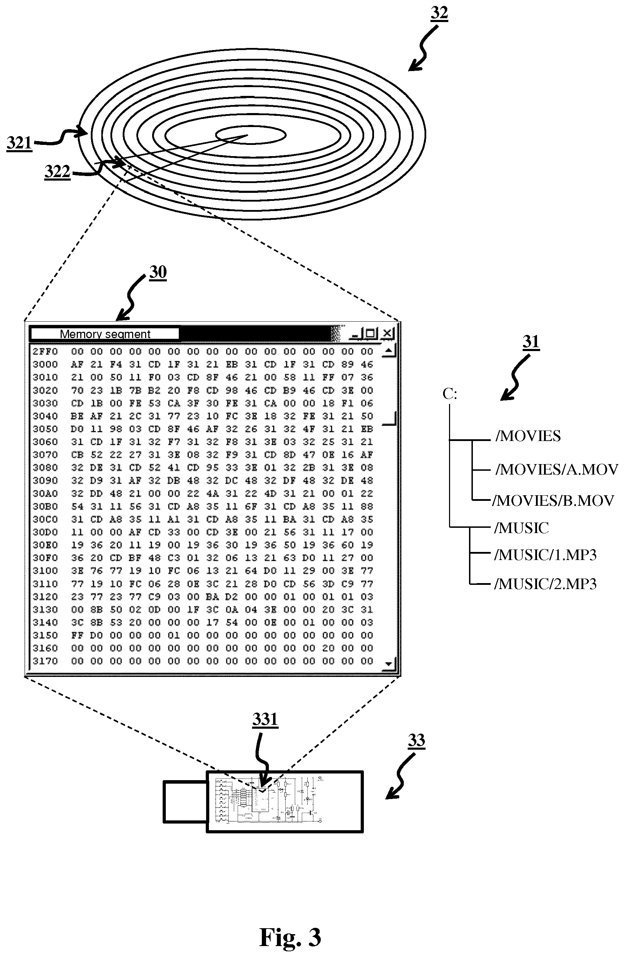

**Figure 3** further illustrates the present principles of evaluating performance of a storage device through binary read-write testing. Element **30** is a memory segment of a storage device used for providing DVR/PVR functions. Element **32** is a hard disk of a hard disk drive. Element **33** is a memory stick. Element **31** is a file system with directories, subdirectories and files, that is for example stored by devices **32** and **33**. Elements **32** and **33** are illustrated as alternative implementations of storage devices. Other embodiments not illustrated can be used for the purpose of the present principles, such as an SD card or any kind of Solid State memory, such as a solid state disk (SSD). Typical of the hard disk **32** is an organization in concentric tracks **321** and sectors **322**. Typical of the memory stick is the presence of a non-volatile RAM memory **331**. Broken lines indicate where on the devices **32** and **33** the memory segment **30** is stored: in a sector **322** on hard disk **32**, and in a memory chip **331** on memory stick **33**. Read-write performance of the storage devices **32** and **33** can be tested by a host device, e.g., STB **11** of figures 1 or 2. For this purpose, a binary memory segment **30** is read from a start address x (e.g., 0x2FF0 as illustrated) on the storage device for a length *n* (e.g., 0x1000), e.g., from storage device **32** or **33**, and saved via the host device **11** to storage space available to the host device **11** other than the storage device (e.g., to NVM **110**, to a network storage space, or to a cloud storage space). 'Binary memory segment' means here that the memory segment is not read using the file system organization of device **32** or **33**, but directly at driver level as raw data. Start address *x* and segment length *n* can be determined according to various parameters. Unplugging of the storage device while read-write tests are ongoing may result in data being corrupted on the storage device. The data corruption may be more or less severe. Preferably, the start address *x* and length *n* are chosen such that the memory segment does not fall within a File Allocation Table (FAT), Master Boot Record (MBR) or GUID Partition Table (GPT) zone, since an ongoing read-write test in this zone that is interrupted due to unplugging of the storage device may cause a complete data loss if the original contents of the data segment, as stored on the host device, is not restored on the storage device. Variant embodiments discussed further and propose solutions for data recovery in a case where an ongoing read-write test is interrupted. Many storage devices also keep a backup copy of the FAT/MBR/GPT at the end of the storage space of the storage device. Preferably, the main and the backup FAT/MBR/GTP zones are thus avoided for executing binary read-write tests. For example, if a storage device is of size *m*, it is safe to use as a start address *m*/2 *- n*/2, wherein *n* is the length of the segment starting at *m*/2 and is chosen as a fraction of *m*, for example 1/5^{th}, 1/10^{th} or 1/20^{th} of *m*, in order to stay out of the FAT/MBR/GPT zones. The length of the segment has an influence on the duration of the performance evaluation, notably because the performance evaluation comprises copying of the read-write test segment to the host device (=backup), and rewriting the copied read-write test segment saved on the host, from the host to the storage device at the end of the read-write testing (=restore) as will be further discussed. The delay caused by the backup and restore operations, in addition to the rules defined above that help to exclude performing read-write tests in the FAT/MBR/GPT zones, can thus be considered to define the length of the segment. Preferably, the length of the segment is chosen such that the performance evaluation can be done in a short time, for example, in 15, 30, 60 or 120 seconds, to avoid penalizing a user that plugs in a storage device because he/she is watching a tv program that he/she wants to record or that he/she wants to pause.

When the storage device is connected, the device driver attributes a physical name to the storage device, e.g., /dev/sda, or /dev/sda1 and /dev/sda2 if the device has two partitions. Binary read (and write) operations can be done directly from (to) these partitions that are mounted on the host device. For example, the binary segment may span over several files when memory segment start address x corresponds to somewhere in one file and the memory segment end address corresponds to somewhere in another file stored on the storage device.

Then a read-write operations performance test of the storage device **32** or **33** is executed by the host device on the memory segment in the storage device **32** or **33** that corresponds to binary segment **30**. For this purpose, binary read-write tests are executed. 'Binary' in this context means, that the read-write operations are executed on a low abstraction level; for example, at driver level. When the read-write performance testing is completed, the copy of the memory segment on the storage device used for the performance test is retrieved (backed up) from storage space available to the host device (other than the storage device) and is restored to the storage device by a binary write operation to the memory segment on the storage device at its original place. This way, the memory contents of the storage device are restored to its original state, i.e., the state it had before execution of the binary read-write tests. The binary read-write performance is tested through a set of binary read-write operations and evaluating time required to complete these operations. The set may comprise one, two, ten, hundred or thousand or more read-write operations.

According to a variant embodiment, the binary read-write tests comprise the determining of a read-write bit rate. For example, a minimum, a maximum or a mean bit rate is determined. For example, to determine a mean bit rate, a delay is defined in which repetitive read-write tests are done. When the delay expires, the number of completed read-write test iterations is totalized. The amount of data read-written and the number of completed iterations then allow to determine the mean read-write bit rate. For example, to determine a maximum read-write bit rate, a delay is defined in which repetitive read-write tests are done. When the delay expires the maximum read-write bit rate is then obtained by dividing the amount of data read-written in each iteration of the completed read-write tests by the time needed to complete the iteration, comparing the results for all completed iterations and selecting the highest read-write bit rate. For example, to determine a minimum read-write bit rate, the results for all completed iterations are compared and the lowest bit rate is selected. Determining the minimum and maximum bit rate in addition to the determining the mean bit rate is advantageous for determining a precise profile of the storage device. For example, while a storage device has a mean bit rate that is sufficient for providing DVR/PVR functions, the minimum bit rate is lower than a minimum threshold bit rate, in which case the minimum bit rate rather than the mean bit rate is a good indicator for determining the performance profile of the storage device. Performance profiles are handled further on. For example, while mean and minimum read-write bit rates are sufficient for supporting DVR/PVR functions, the variance between minimum and maximum read-write bit rates may exceed a tolerance, in which case the storage device may be considered as too unreliable for providing DVR/PVR functions.

According to a variant embodiment that can advantageously combined with the previous embodiments, the binary read-write tests comprises determining of a maximum number of simultaneous read-write operations.

As mentioned above, a performance profile is established according to the result of the binary read-write tests. The performance profile indicates for which use the storage device is suited for. For example, a performance profile indicates that the storage device is suited for storing and playback of Standard Definition (SD), High Definition (HD) or Ultra-High Definition (UHD) type content through a classification in a maximum supported video resolution class. For example, the performance profile may indicate through a classification in a multiple recording class that the storage device is suitable for simultaneous recording of multiple audio/video streams. The simultaneous recording of multiple audio/video streams may for example allow to record streams from several TV channels simultaneously, or for example to record one TV channel while time shifting another TV channel. For example, the performance profile indicates through a classification in a time shift class that the storage device is suitable for simultaneous recording of an audio/video stream and playback of the recorded audio/video stream for time shift purposes, while a classification in a single recording class indicates that the storage device is suited for non-simultaneous single recording and single playback not including time shift. For example, the performance profile indicates through a classification a UHD class that the storage device is suitable for UHD recording and playback, while it is suited for HD time shift and thus for SD time shift, but excluding UHD time shift. For example, the performance profile may indicate that the storage device is suited for UHD time shift, and thus for HD and SD time shift. According to a particular embodiment, the classification can be operated according to previous mentioned thresholds of mean, minimum and/or maximum bit rate. The table hereunder gives a simple and straight forward example of performance profiles based on mean read-write bit rate thresholds. It does for example not take in to account the previous discussed measuring of minimum and maximum read-write bit rates nor does it for example take into account a differentiation of support for according to maximum supported video resolution class.

| **Examples of mean read-write bit rate thresholds** | **Performance profile** |
|---|---|
| < 10Mbit/s | Low bit rate data storage only (e.g., file download). |
| 10-15Mbit/s | Recording |
| >15Mbit/s | time shift (=recording **or** time shift) |
| > 30Mbit/s | recording **and** time shift |

Bit rates of audio/video streams may vary according to encoding type, scene, and encoding quality. For example, the highest bit rate of a variable bit rate MPEG-2 encoded SD stream of a football match may approach a highest bit rate of a variable bit rate HEVC encoded HD stream of the same. According to a variant embodiment, the thresholds are determined according to the bit rates of the streams that the host audio/video receiver device is to receive, for example according to the highest bit rate that can be expected for streams in the subscripted channels.

Among advantages of the binary operation of the read-write testing according to the present principles are that the binary read-write tests are independent of the file system type, partitioning or formatting used on the storage device, which enables evaluating a performance profile of unformatted storage devices or storage devices comprising a file system that is not supported by the host, or of storage devices comprising encrypted files. Thus, advantageously, the performance profiling according to the present principles allow to determine if, in terms of read-write operation rate, a storage device is suitable for being used with the host device to implement DVR/PVR features. For example, a host device that only supports the Linux file system "ext", can execute a performance profiling evaluation on a storage device formatted according to a HFS file system of Apple Inc. Then, if the result of the performance test is satisfying, the host may inform a user that the performance test was successful, that the storage device may be used as a storage device for providing DVR/PVR functions, and may ask the user if he/she agrees with reformatting the storage device with a file system compatible with that used by the host. The reformatting is for example only proposed if the outcome of the performance evaluation is that the storage device is suited for DVR/PVR use with the host device.

According to a variant embodiment, the performance profile is stored on the host device. According to a variant embodiment, the performance profile is related to an identification of the storage device or to a type of storage device, e.g., comprising the model and make of the storage device. According to a variant embodiment this relation is stored on the host device. Then, when the storage device is removed and replaced by another of a same type or of a same model and make, it can be determined from the stored performance profiles that a stored performance profile already exists for the device and that it is not necessary to perform the performance test again. Multiple performance profiles can be stored, for example in a table of a database. According to a variant embodiment, the performance profile is stored on the storage device. According to a variant embodiment, the performance profile is stored in a storage space in a network to which the host device is connected. Then, if a storage device is connected to a host device, the host device interrogates the network to find out if a performance profile exists for the model and make of storage device. If so, it is not necessary to retest the storage device and the results of the performance test stored in the network can be retrieved by the host device. Advantageously, host devices thus share a common knowledge base using a network storage space for storing performance profiles of storage devices, so that a performance profile, once established by any of a plurality of host devices, can be retrieved by any of the plurality of host devices later on, thereby avoiding that for a same model and make of storage device multiple performance evaluations are done.

According to a variant embodiment, a protection is provided against unplugging of the storage device when the binary read-write testing is ongoing, as this can cause a data corruption on the storage device as has been discussed above. To this end, when the storage device is unplugged during binary read-write testing, the host device detects the unplugging and generates an audible and/or visible message to incite the user to re-plug the storage device to avoid data corruption on the storage device. According to a variant embodiment, when the storage device is re-plugged, it is verified that the segment used for the read-write tests is in the same state as it was before the unplugging. If it is in the same state, the read-write tests can continue; if not, the storage device has been used in between or a different storage device has been plugged instead. The read-write tests are aborted and the data saved (backed up) via the host device are not restored to the segment of the storage device to avoid overwriting of data on the storage device.

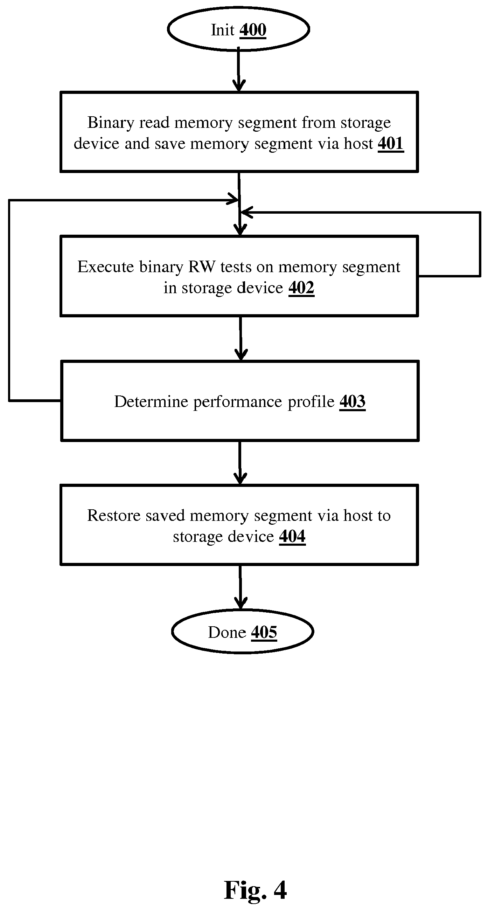

**Figure 4** is a flow chart according to a particular embodiment of a method according to the present principles, as implemented by a host device, such as device **11** of figure 2. Step **400** is an initialization step in which variables used during the execution of the steps are initialized. In a step **401**, a memory segment is read from a storage device from a memory start address, or in other words copied, saved, backed up or cached via the host device, that is, e.g., in a memory of the host device itself, e.g., in a non-volatile memory, or in a network storage attached to the host device or in a cloud storage available to the host device via a network connection. The storage device is for example storage device **12** depicted in figure 2. In a step **402**, one or more binary read-write tests are executed on the memory segment in the storage device. In a step **403**, a performance profile is determined for the storage device according to a result of the binary read-write tests executed in step **402**. For establishing the performance profile, binary read-write test step **402** may be iterated, for example for executing iterations of binary read-write tests that allow to determine a mean, a minimum or a maximum read-write bit rate, or that allow to determine a maximum number of simultaneously executable read-write operations. Then, in a step **404**, after having determined the performance profile in step **403**, the memory segment cached via the host device is rewritten or restored to the host device to the memory start address, thereby restoring the storage device to its original state; that is, the state it had before executing the binary read-write tests. The method ends with step **405**. The storage device can now be used for DVR/PVR functions provided the outcome of the performance profiling is that the storage device enables these functions, be used for data storage only (e.g., for file download) if the performance profile is insufficient for providing DVR/PVR functions, or be unplugged and reused for other purposes. A message may be shown to the user indicating the performance profile as evaluated for the storage device. If the performance profile is sufficient for use of the storage device for DVR/PVR functions for example, the message may ask the user if any data present on the storage device may be overwritten, or may propose the opportunity for the user to unplug the storage device, backup the data present on the storage device, and re-plug the storage device.

As will be appreciated by one skilled in the art, some elements in the drawings may not be used or be necessary in all embodiments. Some operations may be executed in parallel. Variant embodiments other than those illustrated and/or described are possible. For example, while in figures 1-2 the storage device is directly connected to the host device, the skilled in the art will appreciate that the storage device can also be a network storage device, for example connected to a Local Area Network, without diverting from the present principles. For example, the skilled person will readily understand that the storage device **12**, depicted in figures 1-2 as being external to host device **11**, can also be internal to the host device without departing from the present principles. Likewise, the host device, depicted in figures 1-2 as a set top box, can be another type of device, such as an access gateway, a digital television, or a smart phone, not necessarily receiving audio/video streams from satellite, but from cable, via Internet, 4G, or any other type of data transmission medium.

As will be appreciated by one skilled in the art, aspects of the present principles can be embodied as a system, method or computer readable medium. Accordingly, aspects of the present principles can take the form of an entirely hardware embodiment, an entirely software embodiment (including firmware, resident software, micro-code and so forth), or an embodiment combining hardware and software aspects that can all generally be defined to herein as a "circuit", "module" or "system". Furthermore, aspects of the present principles can take the form of a computer readable storage medium. Any combination of one or more computer readable storage medium(s) can be utilized.

Thus, for example, it will be appreciated by those skilled in the art that the diagrams presented herein represent conceptual views of illustrative system components and/or circuitry embodying the principles of the present disclosure. Similarly, it will be appreciated that any flow charts, flow diagrams, state transition diagrams, pseudo code, and the like represent various processes which may be substantially represented in computer readable storage media and so executed by a computer or processor, whether or not such computer or processor is explicitly shown.

A computer readable storage medium can take the form of a computer readable program product embodied in one or more computer readable medium(s) and having computer readable program code embodied thereon that is executable by a computer. A computer readable storage medium as used herein is considered a non-transitory storage medium given the inherent capability to store the information therein as well as the inherent capability to provide retrieval of the information there from. A computer readable storage medium can be, for example, but is not limited to, an electronic, magnetic, optical, electromagnetic, infrared, or semiconductor system, apparatus, or device, or any suitable combination of the foregoing. It is to be appreciated that the following, while providing more specific examples of computer readable storage mediums to which the present principles can be applied, is merely an illustrative and not exhaustive listing, as is readily appreciated by one of ordinary skill in the art: a hard disk, a read-only memory (ROM), an erasable programmable read-only memory (EPROM or Flash memory), a portable compact disc read-only memory (CD-ROM), an optical storage device, a magnetic storage device, or any suitable combination of the foregoing.

## Claims

1. A method for evaluating performance of a storage device (12) connected to a host device (11), wherein the method is implemented by said host device, the method comprising:
binary reading (401) a memory segment (30) from said storage device;
saving said memory segment via said host device to a storage space different from said storage device;
executing (402) binary read-write tests on said memory segment in said storage device;
determining (403) a performance profile for said storage device according to a result of said binary read-write tests executed on said memory segment in said storage device; and
restoring (404) said saved memory segment to said storage device by binary writing said saved memory segment via said host device to said memory segment in said storage device.

2. The method according to claim 1, wherein said executing binary read-write tests on said memory segment in said storage device comprises determining a read-write bit rate.

3. The method according to claim 1 or 2, wherein said executing binary read-write tests on said memory segment in said storage device comprises determining a maximum number of supported simultaneous read-write operations.

4. The method according to any of claims 1 to 3, wherein said determining of said performance profile comprises classifying of said storage device in a video resolution class for storing and retrieving video data from said storage device according to said result of said binary read-write tests executed on said memory segment in said storage device.

5. The method according to claim 4, wherein said video resolution class is one of a standard definition video resolution class, a high definition video resolution class, or an ultra-high definition video resolution class.

6. The method according to any of claims 4 to 5, wherein said determining of said performance profile comprises classifying of said storage device in a personal video recording type class according to a said determined read-write bit rate.

7. The method according to claim 6, wherein said personal video recording type class is one of:
a recording or time shift class;
a recording and time shift class.

8. The method according to any of claims 1 to 7, said performance profile is saved in said host device.

9. The method according to any of claims 1 to 8, said performance profile is saved in a network storage area.

10. A host device (11) for evaluating read-write performance of a storage device (12) connected to said host device, comprising a processor (116) and memory (110, 111) configured to:
binary read a memory segment from said storage device;
save said binary read memory segment via said host device to a storage space different from said storage device;
execute binary read-write tests on said memory segment in said storage device;
determine a performance profile for said storage device according to a result of said binary read-write tests executed on said memory segment in said storage device; and
restore said saved memory segment to said storage device by binary writing said saved memory segment via said host device to said memory segment in said storage device.

11. The host device according to claim 10, wherein said processor and said memory are further configured to determine a read-write bit rate from said binary read-write tests executed on said memory segment in said storage device.

12. The host device according to claim 10 or 11, wherein said processor and said memory are further configured to determine a maximum number of supported simultaneous read-write operations.

13. The host device according to any of claims 10 to 12, wherein said processor and said memory are further configured to classify said storage device in a video resolution class for storing and retrieving video data from said storage device according to a maximum supported read-write bit rate determined from said binary read-write tests.

14. The host device according to claim 13, wherein said processor and said memory are further configured to classify said storage device in a personal video recording type class according to a said determined read-write bit rate.

15. The host device according to any of claims 10 to 14, said processor and said memory are further configured to store said performance profile in said host device.
